(19) Europäisches Patentamt
European Patent Office
Office européen des brevets

(11) **EP 0 488 624 B1**

(12) **EUROPEAN PATENT SPECIFICATION**

(45) Date of publication and mention
of the grant of the patent:
**20.08.1997 Bulletin 1997/34**

(51) Int Cl.6: **H04L 27/22**

(21) Application number: **91310833.8**

(22) Date of filing: **25.11.1991**

(54) **A digital quadrature phase detection circuit**

Eine digitale Schaltung zur Quadraturphasenfeststellung

Un circuit numérique de détection de phase en quadrature

(84) Designated Contracting States:
**DE FR GB IT NL SE**

(30) Priority: **24.11.1990 JP 318628/90**

(43) Date of publication of application:
**03.06.1992 Bulletin 1992/23**

(73) Proprietor: **NEC CORPORATION**
**Tokyo (JP)**

(72) Inventor: **Ichihara, Masaki, c/o NEC Corporation**
**Tokyo 108-01 (JP)**

(74) Representative: **Abnett, Richard Charles et al**
**REDDIE & GROSE**
**16 Theobalds Road**
**London WC1X 8PL (GB)**

(56) References cited:
GB-A- 2 234 411          US-A- 4 606 051
US-A- 4 800 575          US-A- 4 849 991

## Description

This invention relates to a phase detection circuit that detects the phase changes of a phase-modulated signal and derives an in-phase component level (I signal) and a quadrature component level (Q signal) of the input signal relative to a reference signal.

Quadrature detectors are conventionally used as a means of detecting phase changes of a high-frequency signal. One example is to be found in United States Patent US-A-4 849 991 (Arnold et al), see especially Figures 2 and 2A thereof. This patent describes a circuit for determining symbol timing for time division multiple access (TDMA) radio systems, which includes an A/D (analog to digital) converter clocked at a sampling rate which is a multiple of the symbol rate by at least a factor of four and preferably a factor of sixteen, this being four times the frequency of the received IF signal. The converter output is applied to a five-stage shift register (Fig.2A). A first adder forms a weighted addition of the stages in the proportions (1,0,-2,0,1) and a second adder forms a weighted addition of the stages in the proportions (0,2,0,-2,0). The inverted and non-inverted outputs of these adders are applied to two four-input multiplexers, which provide I and Q outputs. These are applied to an arc-tangent look-up ROM which outputs a phase value. With a sampling rate of sixteen times the symbol rate, the selected sample for demodulation can be chosen to be close to the desired sampling instant, by no more than 1/32 of a symbol period.

United States Patent US-A-4 606 051 (Crabtree et al) describes a quadrature phase-shift keying demodulator which has an A/D converter connected to a tapped delay line. The signals are sampled at four times the carrier frequency, or three times the bit rate. The delay line has two groups of alternating signal taps which are multiplied by coefficients and the resultants summed to produce in-phase and quadrature components. The relative magnitude of these two components is used to determine the phase angle. United States Patent US-A-4 800 575 (Anderson) describes a frequency shift keying demodulator of somewhat similar construction.

The invention provides a digital quadrature-phase detector circuit comprising:

A/D converter means for converting an analog phase-modulated signal into a digital signal at a sampling rate determined by a clock signal having a frequency **n** times the carrier frequency of the analog signal, **n** being a positive integer;

a plurality of **n** delay means connected in series to the output of the A/D converter means and numbered counting from the A/D converter means, each delay means delaying an input thereto by one period of the clock signal to provide an output therefrom;

a plurality of weighting means for relatively weighting the said digital signal and the outputs of the plurality of delay means to provide weighted signals;

first adder means for adding the weighted digital signal and the weighted outputs of even-numbered delay means; and

second adder means for adding the weighted outputs of odd-numbered delay means;

characterised by first and second latching means for respectively latching the outputs of the first and second adder means in synchronization with a latching signal having a period $\underline{m}$ times longer than the period of the clock signal, $\underline{m}$ being a positive integer, to produce in-phase and quadrature components of the phase-modulated signal, in which $\underline{n} = \underline{m}$ and $\underline{n} > 1$.

The invention also provides a method of detecting a analog phase-modulated signal to produce its in-phase and quadrature components, the method comprising the steps of:

converting the analog phase-modulated signal into a digital signal in synchronization with a clock signal having a frequency n times higher than the carrier frequency of the phase-modulated signal, $\underline{n}$ being a positive integer;

sequentially delaying the digital signal $\underline{n}$ times each by one period of the clock signal;

weighting the digital signal and the signals delayed 2$\underline{p}$-times with a first set of predetermined weighting factors to produce a first set of weighted signals, $\underline{p}$ being 1, 2, ... $\underline{n}$/2;

weighting the signals delayed (2$\underline{p}$-1)-times to produce a second set of weighted signals;

adding the first set of weighted signals to produce a first added signal; and

adding the second set of weighted signals to produce a second added signal;

characterised by latching the first and second added signals with a latching signal having a period $\underline{m}$ times longer than the period of the clock signal to produce the I and Q components, respectively, where $\underline{n} = \underline{m}$ and $\underline{n} > 1$.

A preferred embodiment of the apparatus and method of the invention, described below with reference to the drawing, incorporates an A/D converter using a sampling clock having a frequency four times higher than the carrier of the quadrature-modulated signal ($\underline{n} = 4$). The digital signal is delayed by one sampling slot in each of four delay circuits connected in series to the A/D converter. The output of the A/D converter and that of the fourth delay circuit are multiplied by -1/2 by respective digital weighting circuits, and the multiplied outputs together with the output of the second delay circuit are added together in an adder to generate an I component (in-phase) signal. The output of the first delay circuit is multiplied by -1 by another weighting circuit, and this multiplied output and the output of the third delay circuit are added together in another adder to generate a Q component (quadrature phase) signal. The I and Q signals are held in latches which are clocked at one quarter of the sampling clock rate ($\underline{m}$ = 4).

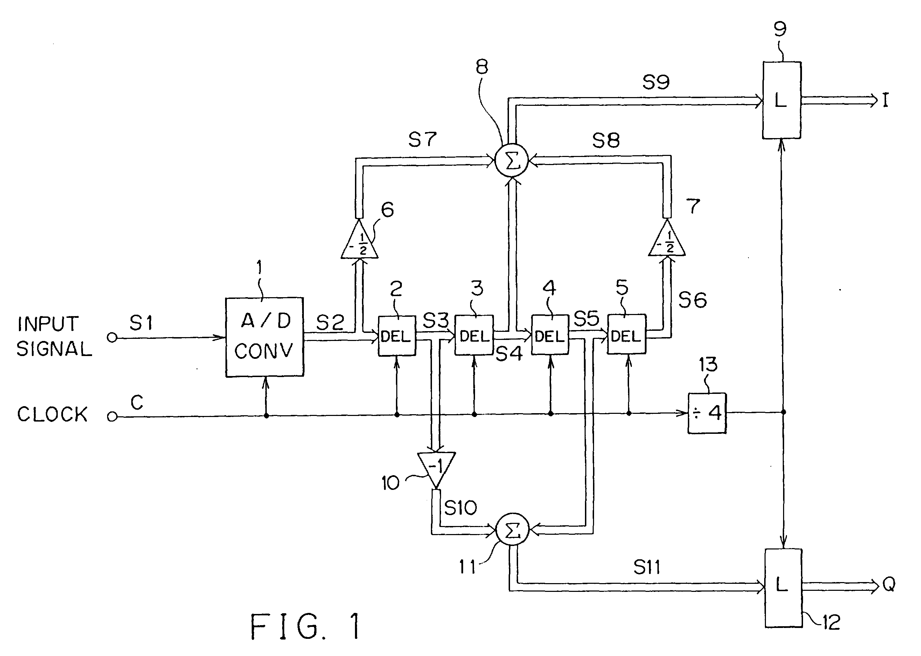

The invention will now be described in more detail, by way of example, with reference to the drawing, in which the sole figure, referred to as FIG.1, is a block diagram illustrating a preferred phase detection circuit embodying the present invention.

In FIG.1, an A/D (analog to digital) converter 1 converts an input signal S1 to a digital signal S2 in synchronization with a sampling clock C having a frequency $\underline{n}$ times, in this case four times, higher than the carrier frequency of signal S1. The digital signal S2 is delayed by one sampling cycle of clock C by $\underline{n}$ (four) delay circuits 2, 3, 4 and 5, respectively, which output respective delayed signals S3, S4, S5, and S6. The digital signal S2 is weighted by a weighting factor of - ½ at a weighting circuit 6 to become a signal S7. The output S6 of the fourth delay circuit 5 is weighted by a weighting factor of -½ at a weighting circuit 7 to become a signal S8. The outputs S7 and S8 in addition to the output S4 of the second delay circuit 3 are added by a first adder 8, the output of which (S9) is latched in a first output latching circuit 9 at a cycle $\underline{m}$ times, also in this case four times, longer than the sampling clock cycle. This latching cycle clock is obtained by dividing the sampling clock C at a divider 13. The latched signal is outputted as an I signal (in-phase component level).

In addition, a weighting circuit 10 weights the output S3 of the first delay circuit 2 with a weighting factor of -1 to reverse the polarity of same and thereby to produce an output S10. The output S10 and the output S5 of the third delay circuit 4 are added by a second adder 11. The output of the second adder 11 is then latched in a second output latching circuit 12 at the latching cycle provided from the divider 13. This latched signal is outputted as a Q signal (quadrature component level).

More generally, one can say that the digital signal from the converter 1 and the $2\underline{p}$ time delayed signals (where $\underline{p}$ is 1,2, ... $\underline{n}/2$) are combined in adder 8 with a first set of predetermined weighting factors, and the ($2\underline{p}$-1) time delayed signals are combined in adder 11 with a second set of predetermined weighting factors.

The above-described operation can be described by the following mathematical expressions. Let the input signal S1 be:

$$\times = A\cos(\omega_c t + \phi) + v \tag{1}$$

and let the sampling timing within the A/D converter 1 be:

$$t = nT \tag{2}$$

where:

$\omega_c$ = the angular frequency of the carrier of the input signal S1 (radians/sec)
$t$ = time (sec)
$\phi$ = the phase of input signal S1 (radians)
$v$ = the DC off-set

$$n = -\infty, ..., -2, -1, 0, 1, 2, ..., \infty \tag{3}$$

$$T = 2\pi/4\omega_c : \text{the sampling cycle (with the sampling frequency 4-times higher than the carrier frequency)} \tag{4}$$

According to the above definitions, the signals S2, S3, S4, S5, and S6 are respectively expressed as:

$$S2 = Acos(\omega_c nT + \phi) + v$$
$$S3 = Acos(\omega_c(n-1)T + \phi) + v$$
$$S4 = Acos(\omega_c(n-2)T + \phi) + v \quad . . . . . . . . . (5)$$
$$S5 = Acos(\omega_c(n-3)T + \phi) + v$$
$$S6 = Acos(\omega_c(n-4)T + \phi) + v.$$

If we now let n = 4m+k, where:

$$m = -\infty, ..., -2, -1, 0, 1, 2, ..., \infty$$

and

$$k = 0, 1, 2, 3,$$

then the expressions (5) become:

$$S2 = Acos(\omega_c(4m+k)T + \phi) + v$$
$$S3 = Acos(\omega_c(4m+k-1)T + \phi) + v$$
$$S4 = Acos(\omega_c(4m+k-2)T + \phi) + v \quad . . . . . . . . (6)$$
$$S5 = Acos(\omega_c(4m+k-3)T + \phi) + v$$
$$S6 = Acos(\omega_c(4m+k-4)T + \phi) + v.$$

Substituting the expression (4) into the expressions (6) and allowing the latching timing in the output circuits 9 and 12 to be at the time when k=2, then each delay signal can be expressed as:

$$S2 = Acos(2\pi m + \pi + \phi) + v$$
$$S3 = Acos(2\pi m + \pi/2 + \phi) + v$$
$$S4 = Acos(2\pi m + \phi) + v \quad . . . . . . . . (7)$$
$$S5 = Acos(2\pi m - \pi/2 + \phi) + v$$
$$S6 = Acos(2\pi m - \pi + \phi) + v.$$

which simplify to:

$$S2 = -Acos(\phi) + v$$
$$S3 = -Asin(\phi) + v$$
$$S4 = Acos(\phi) + v \quad . . . . . . . . . . . . . (8)$$
$$S5 = Asin(\phi) + v$$
$$S6 = -Acos(\phi) + v.$$

Accordingly, the values that are latched within the output latching circuits 9 and 12 are:

$$I = -S2/2 + S4 - S6/2$$

$$= -(Acos(\phi)+v)/2 + Acos(\phi)+v - (Acos(\phi)+v)/2$$

$$= 2A\cos(\phi) \tag{9}$$

$$Q = -S3 + S5$$

$$= -(A\sin(\phi)+v) + A\sin(\phi)+v$$

$$= 2A\sin(\phi) \tag{10}$$

As a result, the phase $\phi$ is derived as:

$$\phi = \tan^{-1}(Q/I) \tag{11}$$

It should be noted that the weighting circuits 6, 7, 10 and the like can easily be realized by using circuitry that shifts the digits of the data, or by bit reversing, and as a result no complicated multipliers are required.

As described above, the circuit enables quadrature phase detection of a phase-modulated wave by using an A/D converter, delay circuits, adders and latching circuits, and the DC off-set voltage in the input signal is completely eliminated in the process, which in turn eliminates phase errors. Since no analog devices such as ninety-degree phase shifters or mixers are used, which are difficult to implement and balance accurately, phase errors caused by the imperfections of such devices are eliminated. In addition, since circuits other than the A/D converter are implemented with digital circuits, and therefore large scale integration (LSI) technologies can be used, the size and power consumption of the quadrature phase detection circuit can be reduced.

## Claims

1. A digital quadrature-phase detector circuit comprising:

    A/D converter means (1) for converting an analog phase-modulated signal (S1) into a digital signal (S2) at a sampling rate determined by a clock signal (C) having a frequency $\underline{n}$ times the carrier frequency of the analog signal, $\underline{n}$ being a positive integer;
    a plurality of **n** delay means (2-5) connected in series to the output of the A/D converter means and numbered counting from the A/D converter means, each delay means delaying an input thereto by one period of the clock signal to provide an output (S3-S6) therefrom;
    a plurality of weighting means (6, 7, 10) for relatively weighting the said digital signal (52) and the outputs (S3-S6) of the plurality of delay means to provide weighted signals;
    first adder means (8) for adding the weighted digital signal (S7) and the weighted outputs (S4,S6) of even-numbered delay means (3,5); and
    second adder means (11) for adding the weighted outputs (S3,S5) of odd-numbered delay means (2,4);

    characterised by first and second latching means (9,12) for respectively latching the outputs (S9-S11) of the first and second adder means (8,11) in synchronization with a latching signal having a period $\underline{m}$ times longer than the period of the clock signal, $\underline{m}$ being a positive integer, to produce in-phase and quadrature components (I,Q) of the phase-modulated signal, in which $\underline{n} = \underline{m}$ and $\underline{n} > 1$.

2. A detector circuit as claimed in claim 1, wherein **n** is four.

3. A detector circuit as claimed in claim 2, wherein the plurality of delay means comprises first, second, third and fourth delay circuits (2,3,4,5) connected in series to the A/D converter means (1) for respectively delaying the digital signal by one period of the clock signal (C) to produce first, second, third and fourth delayed signals (S2,S3,S4,S5), and wherein the plurality of weighting means comprises first weighting means (6,7) for weighting the digital signal (S2) and said second and fourth delayed signals (S3,S5) with first, second and third weighting factors, respectively; and second weighting means (10)for weighting the first and third delayed signals (S2,S4) with fourth and fifth weighting factors, and wherein the first adder means comprises means for adding the outputs of the first weighting means, and the second adder means comprises means for adding the outputs of the second weighting means.

4. A detector circuit as claimed in claim 3, wherein the first, second, third, fourth and fifth weighting factors are in the relative proportions -½, 1, -½, -1 and 1, respectively.

5. A method of detecting a analog phase-modulated signal to produce its in-phase (I) and quadrature (Q) components, the method comprising the steps of:

converting the analog phase-modulated signal into a digital signal in synchronization with a clock signal having a frequency **n** times higher than the carrier frequency of the phase-modulated signal, $\underline{n}$ being a positive integer; sequentially delaying the digital signal $\underline{n}$ times each by one period of the clock signal; weighting the digital signal and the signals delayed $2\underline{p}$-times with a first set of predetermined weighting factors to produce a first set of weighted signals, $\underline{p}$ being 1, 2, ... $\underline{n}$/2; weighting the signals delayed $(2\underline{p}$-1)-times to produce a second set of weighted signals; adding the first set of weighted signals to produce a first added signal; and adding the second set of weighted signals to produce a second added signal;

characterised by latching the first and second added signals with a latching signal having a period **m** times longer than the period of the clock signal to produce the I and Q components, respectively, where $\underline{n} = \underline{m}$ and $\underline{n} > 1$.

6. A method as claimed in claim 5, wherein $\underline{n}$ is four.

7. A method as claimed in claim 6, wherein the first set of weighting factors are in the relative proportions -½, 1, -½, and the second set of weighting factors are in the relative proportions -1,1.

**Patentansprüche**

1. Digitale Quadraturphasendetektorschaltung mit:

einer A/D-Wandlereinrichtung (1) zum Umwandeln eines analogen phasenmodulierten Signals (S1) in ein digitales Signal (S2) mit einer Abtastrate, die durch ein Taktsignal (C) mit einer Frequenz bestimmt ist, die das $\underline{n}$-fache der Trägerfrequenz des analogen Signals beträgt, wobei $\underline{n}$ eine positive Ganzzahl ist; mehreren $\underline{n}$ Verzögerungseinrichtungen (2-5), die in Reihe mit dem Ausgang der A/D-Wandlereinrichtung verbunden und in der Zählung von der A/D-Wandlereinrichtung benummert sind, wobei jede Verzögerungseinrichtung eine Eingabe in sie um eine Periode des Taktsignals verzögert, um eine Ausgabe (S3-S6) aus ihr bereitzustellen; mehreren Gewichtungseinrichtungen (6, 7, 10) zum relativen Gewichten des digitalen Signals (S2) und der Ausgaben (S3-S6) der mehreren Verzögerungseinrichtungen, um gewichtete Signale bereitzustellen; einer ersten Addierereinrichtung (8) zum Addieren des gewichteten digitalen Signals (S7) und der gewichteten Ausgaben (S4, S6) geradzahliger Verzögerungseinrichtungen (3, 5); und einer zweiten Addierereinrichtung (11) zum Addieren der gewichteten Ausgaben (S3, S5) ungeradzahliger Verzögerungseinrichtungen (2, 4);

gekennzeichnet durch eine erste und zweite Zwischenspeicherungseinrichtung zum Zwischenspeichern der Ausgaben (S9-S11) der ersten bzw. zweiten Addierereinrichtung (8, 11) in Synchronisierung mit einem Zwischenspeicherungssignal mit einer Periode, die $\underline{m}$ mal länger als die Periode des Taktsignals ist, wobei $\underline{m}$ eine positive Ganzzahl ist, um eine Gleichtakt- und Quadraturkomponente (I, Q) des phasenmodulierten Signals zu erzeugen, wobei $\underline{n} = \underline{m}$ und $\underline{n} > 1$ ist.

2. Detektorschaltung nach Anspruch 1, wobei $\underline{n}$ gleich vier ist.

3. Detektorschaltung nach Anspruch 2, wobei die mehreren Verzögerungseinrichtungen aufweisen: eine erste, zweite, dritte und vierte Verzögerungsschaltung (2, 3, 4, 5), die in Reihe mit der A/D-Wandlereinrichtung (1) verbunden sind, zum jeweiligen Verzögern des digitalen Signals um eine Periode des Taktsignals (C), um ein erstes, zweites, drittes und viertes verzögertes Signal (S2, S3, S4, S5) zu erzeugen, und wobei die mehreren Gewichtungseinrichtungen aufweisen: eine erste Gewichtungseinrichtung (6, 7) zum Gewichten des digitalen Signals (S2) und des zweiten und vierten verzögerten Signals (S3, S5) mit einem ersten, zweiten bzw. dritten Gewichtungsfaktor;

EP 0 488 624 B1

und eine zweite Gewichtungseinrichtung (10) zum Gewichten des ersten und dritten verzögerten Signals (S2, S4) mit einem vierten und fünften Gewichtungsfaktor, und wobei die erste Addierereinrichtung eine Einrichtung zum Addieren der Ausgaben der ersten Gewichtungseinrichtung aufweist, und die zweite Addierereinrichtung eine Einrichtung zum Addieren der Ausgaben der zweiten Gewichtungseinrichtung aufweist.

**4.** Detektorschaltung nach Anspruch 3, wobei der erste, zweite, dritte, vierte und fünfte Gewichtungsfaktor in den relativen Proportionen -½, 1, -½, -1 bzw. 1 sind.

**5.** Verfahren zum Detektieren eines analogen phasenmodulierten Signals, um seine Gleichtakt-(I) und Quadratur-(Q)-Komponente zu erzeugen, wobei das Verfahren die folgenden Schritte aufweist:

Umwandeln des analogen phasenmodulierten Signals in ein digitales Signal in Synchronisierung mit einem Taktsignal mit einer Frequenz, die $n$ mal höher als die Trägerfrequenz des phasenmodulierten Signals ist, wobei $n$ eine positive Ganzzahl ist;
aufeinanderfolgendes Verzögern des digitalen Signals $n$ mal jeweils um eine Periode des Taktsignals;
Gewichten des digitalen Signals und der $2p$ mal verzögerten Signale mit einem ersten Satz vorbestimmter Gewichtungsfaktoren, um einen ersten Satz gewichteter Signale zu erzeugen, wobei $p$ gleich 1, 2, ... $n/2$ ist;
Gewichten der $(2p-1)$ mal verzögerten Signale, um einen zweiten Satz gewichteter Signale zu erzeugen;
Addieren des ersten Satzes gewichteter Signale, um ein erstes addiertes Signal zu erzeugen; und
Addieren des zweiten Satzes gewichteter Signale, um ein zweites addiertes Signal zu erzeugen;

gekennzeichnet durch Zwischenspeichern des ersten und zweiten addierten Signals mit einem Zwischenspeicherungssignal mit einer Periode, die $m$ mal länger als die Periode des Taktsignals ist, um die I- bzw. Q-Komponente zu erzeugen, wobei $n = m$ und $n > 1$ ist.

**6.** Verfahren nach Anspruch 5, wobei $n$ gleich vier ist.

**7.** Verfahren nach Anspruch 6, wobei der erste Satz von Gewichtungsfaktoren in den relativen Proportionen -½, 1, -½ und der zweite Satz von Gewichtungsfaktoren in den relativen Proportionen -1, 1 ist.

## Revendications

**1.** Circuit numérique de détection de phase en quadrature comportant :

un moyen convertisseur A/N (1) pour convertir un signal analogique (S1) modulé en phase en un signal numérique (S2) à une fréquence d'échantillonnage déterminée par un signal d'horloge (C) ayant une fréquence égale à $n$ fois la fréquence porteuse du signal analogique, $n$ étant un nombre entier positif;
une pluralité de $n$ moyens de retard (2-5) connectés en série à la sortie du moyen convertisseur A/N et un comptage numéroté à partir du moyen convertisseur A/N, chaque moyen de retard retardant une entrée à celui-ci d'une période du signal d'horloge pour fournir une sortie (S3-S6) de celui-ci;
une pluralité de moyens de pondération (6, 7, 10) pour pondérer relativement ledit signal numérique (S2) et les sorties (S3-S6) de la pluralité de moyens de retard pour fournir des signaux pondérés;
un premier moyen additionneur (8) pour additionner le signal numérique pondéré (S7) et les sorties pondérées (S4, S6) des moyens de retard (3, 5) de numéros pairs; et
un deuxième moyen additionneur (11) pour additionner les sorties pondérées (S3, S5) des moyens de retard (2, 4) de numéros impairs;

caractérisé par des premier et deuxième moyens de verrouillage (9, 12) pour verrouiller respectivement les sorties les sorties (S9-S11) des premier et deuxième moyens additionneurs (8, 11) en synchronisation avec un signal de verrouillage ayant une période $m$ fois plus longue que la période du signal d'horloge, $m$ étant un nombre entier positif, pour produire des composantes (I, Q) en phase et en quadrature du signal modulé en phase, dans lesquelles $n = m$ et $n > 1$.

**2.** Circuit de détection selon la revendication 1, dans lequel $n$ est égal à quatre.

**3.** Circuit de détection selon la revendication 2, dans lequel la pluralité de moyens de retard comporte des premier, deuxième, troisième et quatrième circuits de retard (2, 3, 4, 5) connectés en série au moyen convertisseur A/N

7

(1) pour retarder respectivement le signal numérique d'une période du signal d'horloge (C) pour produire des premier, deuxième, troisième et quatrième signaux retardés (S2, S3, S4, S5), et dans lequel la pluralité de moyens de pondération comporte un premier moyen de pondération (6, 7) pour pondérer le signal numérique (S2) et lesdits deuxième et quatrième signaux retardés (S3, S5) avec des premier, deuxième et troisième facteurs de pondération, respectivement; et un deuxième moyen de pondération (10) pour pondérer les premier et troisième signaux retardés (S2, S4) avec des quatrième et cinquième facteurs de pondération, et dans lequel le premier moyen additionneur comporte des moyens pour additionner les sorties du premier moyen de pondération, et le deuxième moyen additionneur comporte des moyens pour additionner les sorties du deuxième moyen de pondération.

4. Circuit de détection selon la revendication 3, dans lequel les premier, deuxième, troisième, quatrième et cinquième facteurs de pondération sont dans les proportions relatives -½, 1, -½, -1 et 1, respectivement.

5. Procédé de détection d'un signal analogique modulé en phase pour produire ses composantes en phase (I) et en quadrature (Q), le procédé comportant les étapes suivantes :

conversion du signal analogique modulé en phase en un signal numérique en synchronisation avec un signal d'horloge ayant une fréquence $n$ fois plus élevée que la fréquence porteuse du signal modulé en phase, $n$ étant un nombre entier positif;

retardement séquentiel du signal numérique et des signaux retardés $2p$ fois avec un premier ensemble de facteurs de pondération prédéterminés pour produire un premier ensemble de signaux pondérés, $p$ étant égal à 1, 2, ... $n/2$;

pondération des signaux retardés ($2p$ - 1) fois pour produire un deuxième ensemble de signaux pondérés; et addition du premier ensemble de signaux pondérés pour produire un premier signal additionné;

addition du deuxième ensemble de signaux pondérés pour produire un deuxième signal additionné;

caractérisé par le verrouillage des premier et deuxième signaux additionnés avec un signal de verrouillage ayant une période $m$ fois plus longue que la période du signal d'horloge pour produire les composantes I et Q, respectivement, où $n = m$ et $n > 1$.

6. Procédé selon la revendication 5, dans lequel $n$ est égal à quatre.

7. Procédé selon la revendication 6, dans lequel les facteurs de pondération du premier ensemble sont dans les proportions relatives de -½, 1, -½ et les facteurs de pondération du deuxième de ensemble sont dans les proportions relatives de -1, 1.

FIG. 1